# FASCICULE DE BREVET EUROPEEN

(11) **EP 1 043 109 B1**
(45) Date de publication et mention de la délivrance du brevet: **14.07.2004**
(21) Numéro de dépôt: 99106603.6
(22) Date de dépôt: 31.03.1999
(51) Int. Cl.: B23K 20/10

(54) **Procédé d'assemblage par soudage d'une bobine avec un circuit intégré ou une unité électronique de petites dimensions**
Verfahren zum Verbinden von einer Spule mit einer Mikroschaltung oder einer kleinen elektronischen Einheit durch Schweissen
Assembling method through welding of a coil with an integrated circuit or a small electronic unit

(43) Date de publication de la demande: 11.10.2000
(73) Titulaire: EM Microelectronic-Marin SA, 2074 Marin (CH)
(72) Inventeur: Doering, Elko, 2572 Mörigen (CH); Cattin, Pascal, 2088 Cressier (CH); Thiemann, Uwe, 2076 Gals (CH)
(74) Mandataire: Laurent, Jean

(56) Documents cités:
- US-A- 5 057 661
- US-A- 5 186 378
- US-A- 5 493 069

## Description

La présente invention concerne un procédé de soudage des deux parties d'extrémité d'une bobine sur les deux plots ou plages de contact électrique d'un circuit intégré ou d'une unité électronique de petites dimensions. La connexion électrique des deux parties d'extrémité de la bobine sur les plots ou plages de contact électrique s'effectue généralement au moyen d'une thermode prévue à cet effet.

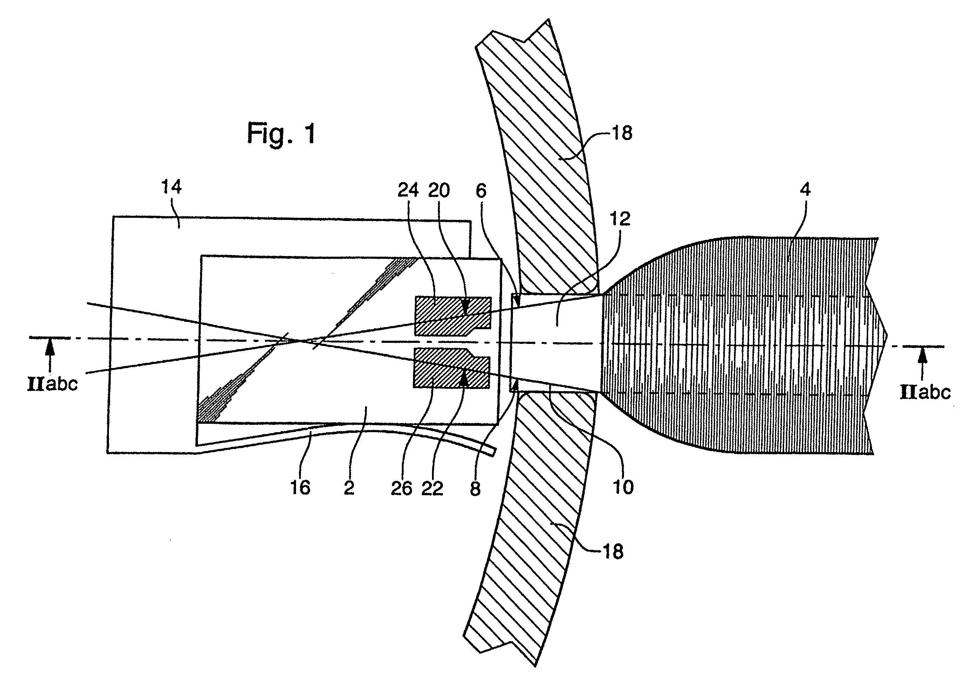

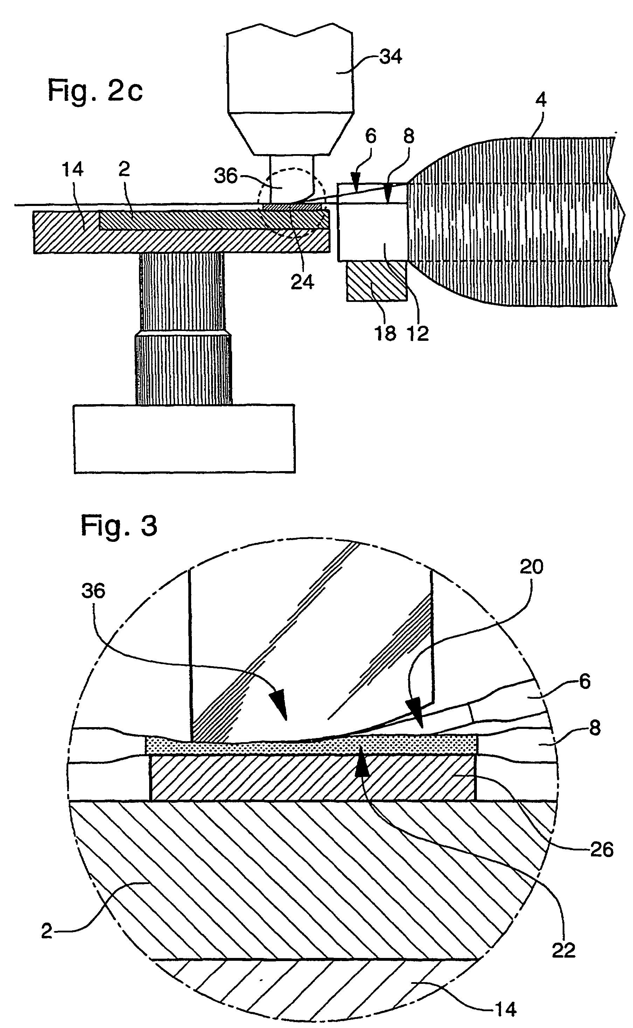

Il est connu notamment du document US 5,572,410 un procédé d'assemblage d'une bobine avec un circuit électronique. Selon ce procédé, il est prévu d'apporter un circuit électronique, en particulier un circuit intégré semi-conducteur et un noyau de bobine placé à proximité. Ensuite, de manière automatique, un fil électrique isolé est enroulé autour du noyau, les deux parties d'extrémité de la bobine étant disposées de manière à être superposées aux plots de contact électrique du circuit électronique (voir figures 1 et 3). Ensuite, les deux parties d'extrémité de la bobine situées directement au-dessus des plots métalliques sont soudées à ces plots au moyen d'un dispositif de soudage automatique qui enlève l'isolation du fil de la bobine, c'est-à-dire la gaine isolante protégeant le fil électrique, simultanément au soudage (colonne 3, lignes 26 à 30).

Il résulte du procédé d'assemblage décrit ci-dessus un inconvénient majeur. En effet, il a été constaté que la mise en oeuvre du procédé décrit ci-avant avec des circuits intégrés engendre dans une proportion relativement importante des dommages au circuit intégré lui-même et en particulier aux couches supérieures, notamment à la couche de passivation.

En effet, le soudage par thermocompression des extrémités du fil isolé de la bobine sur les plages ou plots métalliques du circuit intégré nécessite une certaine pression et une température élevée, par exemple de l'ordre de 500 ° C.

Dans le cas de la présente invention, il a été constaté que la haute température nécessaire à l'élimination de la gaine isolante et au soudage simultané du fil électrique sur les plots ou plages métalliques du circuit intégré engendre des contraintes mécaniques et thermiques importantes, notamment dues à une dilatation des plots ou plages métalliques du circuit intégré. La pression et la chaleur nécessaires au procédé décrit ci-avant engendrent ainsi des micro-fissures dans le circuit intégré pouvant l'endommager et le rendre inutilisable. Ainsi, le rendement industriel avec ce procédé est relativement peu élevé.

Le but de la présente invention est de pallier les inconvénients cités ci-avant en fournissant un procédé de soudage efficace qui protège le circuit ou l'unité électronique de contraintes mécaniques ou thermiques endommageant ce circuit ou cette unité électronique.

A cet effet, la présente invention propose un procédé de soudage de deux parties d'extrémité d'une bobine sur deux plots ou plages de contact électrique d'un circuit intégré ou d'une unité électronique de petites dimensions selon la revendication 1.

Grâce au procédé de soudage selon l'invention, il est possible de souder les deux extrémités du fil électrique formant la bobine au circuit intégré ou à l'unité électronique avec une température relativement faible, notamment inférieure à 200° C. En effet, l'élimination de la gaine isolante peut être effectuée à une température élevée de l'ordre de 500° C alors que la température nécessaire au soudage du fil électrique lui-même sur les plages ou plots métalliques du circuit ou de l'unité électronique nécessite une température bien inférieure. De plus, une relativement faible pression de soudage est nécessaire dans ces conditions. Dans un mode de mise en oeuvre particulier de l'invention, il est prévu de souder les extrémités du fil électrique de la bobine à l'aide d'une tête à ultrasons qui laisse les plots ou plages métalliques à une température proche de la température ambiante.

L'invention sera décrite ci-après plus en détail à l'aide de la description suivante, faite en référence aux dessins annexés donnés à titre d'exemples schématiques nullement limitatifs, dans lesquels :
- la figure 1 est une vue de dessus d'une bobine et d'un circuit intégré dans une disposition permettant de souder les parties d'extrémité du fil de bobine sur les plots métalliques du circuit intégré;
- les figures 2a, 2b et 2c représentent schématiquement un premier mode de mise en oeuvre du procédé selon l'invention;
- la figure 3 est une vue agrandie d'une partie de la figure 2c;
- la figure 4 représente un mode de réalisation perfectionné de l'unité d'élimination de la gaine isolante représentée à la figure 2;
- la figure 5 représente schématiquement un mode de réalisation d'une unité de soudage permettant d'effectuer alternativement l'élimination de la gaine isolante et le soudage des extrémités du fil électrique sur les plots métalliques;
- les figures 6a, 6b et 6c décrivent schématiquement un deuxième mode de mise en oeuvre du procédé selon l'invention.

A la figure 1 est représenté un circuit intégré 2 et une bobine 4 présentant deux parties d'extrémité 6 et 8 agencées de manière similaire à l'art antérieur US 5,572,410 dans lequel l'homme du métiers trouvera d'autres informations détaillées au sujet du procédé d'assemblage selon la présente invention pour ce qui concerne notamment l'enroulement du fil de bobine 10 autour du noyau 12 portant cette bobine. Le circuit électronique est maintenu dans un premier support 14 comprenant un élément élastique 16 servant au maintien rigide du circuit 2. De même, la bobine est maintenue dans le prolongement du circuit 2 par un deuxième support 18 qui comprend des moyens de préhension qui serrent une extrémité du noyau 12. Les parties d'extrémité 6 et 8 du fil 10 formant la bobine présentent deux régions respectives 20 et 22 qui sont superposées respectivement aux deux plages de contact électrique 24 et 26 du circuit 2. En particulier, les plages de contact électrique 24 et 26 sont formées par des plots métalliques (nommés "bumps" selon la terminologie anglaise). Les dimensions de ces plots métalliques peuvent être variables et sont adaptées au procédé de soudage selon l'invention. En général, ces plots sont prévus avec une longueur relativement importante permettant un soudage du fil 10 sur une certaine longueur de manière à assurer une bonne fixation des extrémités 6 et 8 aux plots 24 et 26.

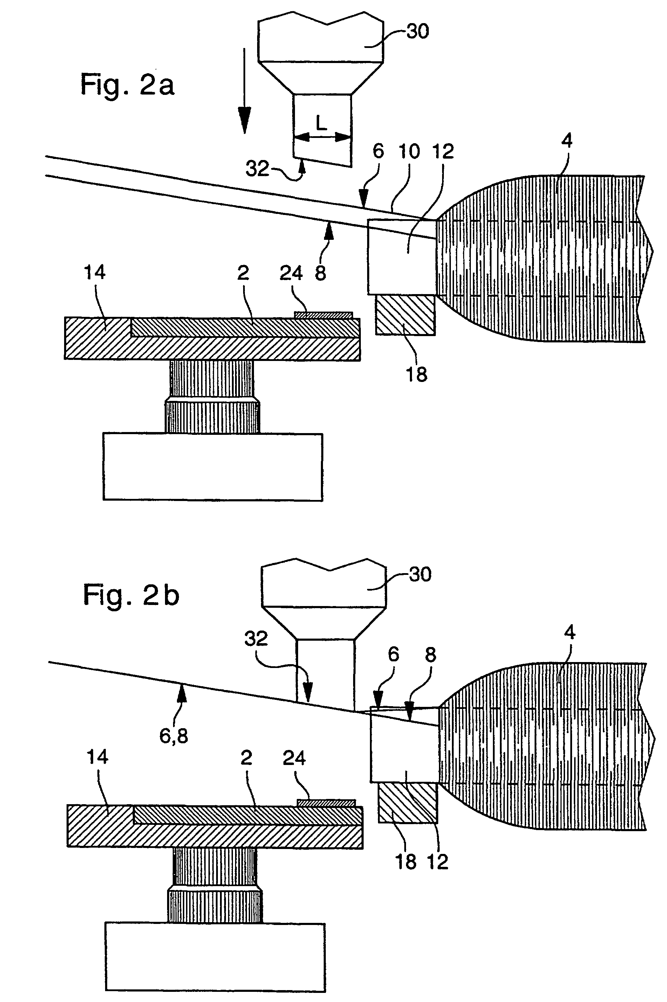

Les figures 2a à 2c comprennent une coupe partielle de la figure 1. Les éléments déjà décrits ci-avant ne seront pas décrits à nouveau en détail par la suite.

Une fois le circuit intégré 2 et la bobine 4 positionnés dans leur support respectif 14 et 18, les parties d'extrémité 6 et 8 du fil 10 sont maintenus à une certaine distance des plots 24 et 26 pour effectuer une étape préliminaire au soudage selon l'invention. Comme représenté aux figures 2a et 2b, une première unité de chauffage 30 présentant un élément de chauffage 32 avec une largeur L sensiblement égale ou supérieure à la longueur des plots 24 et 26 est apportée au-dessus des parties d'extrémité 6 et 8 et descendue en direction de ces parties pour chauffer localement le fil 10 et faire fondre ou sublimer au moins partiellement la gaine isolante entourant le fil électrique. On notera que, de préférence, élément de chauffage 32 présente un inclinaison sensiblement correspondante à l'inclinaison des parties d'extrémité 6 et 8 de manière à limiter les contraintes, notamment en tension, sur les parties d'extrémité 6 et 8. Cette caractéristique est d'autant plus importante lorsque les deux parties 6 et 8 ne sont pas situées initialement dans un même plan. Dans ce dernier cas, il est également possible de prévoir que élément de chauffage 32 présente deux niveaux différents selon une direction perpendiculaire au plan de la figure 2a pour ne pas devoir ramener les deux parties 6 et 8 dans un même plan, comme c'est le cas à la figure 2b.

Comme déjà mentionné, la température usuelle pour fondre ou sublimer la gaine isolante d'un fil électrique utilisé pour un bobinage de petites dimensions s'élève à environ 500 °C. L'unité 30 est donc agencée pour fournir une telle température au niveau de l'élément de chauffage 32. On remarquera qu'aux figures 2a et 2b, l'étape préliminaire au soudage est effectuée au-dessus des plots 24 et 26 du circuit intégré 2, les parties d'extrémité 6 et 8 du fil de bobine étant déjà positionnées de manière à avoir respectivement des régions 20 et 22 superposées aux plots 24 et 26. Toutefois, dans une variante de ce mode de mise en oeuvre, l'étape préliminaire au soudage peut être effectuée avant l'alignement de la bobine et du circuit intégré qui lui est destiné qui est apporté suite à cette étape préliminaire, notamment pour éviter que le matériau formant la gaine se répande sur les plots 24 et 26.

Dans une autre variante de mise en oeuvre du procédé selon l'invention, il est prévu d'effectuer l'étape préliminaire au soudage à un poste situé en amont du poste de soudage proprement dit. Dans ce cas, la bobine 4 subit un déplacement selon une direction perpendiculaire au plan de la figure 2a. A un premier poste, la première unité de chauffage 30 effectue l'élimination de la gaine isolante aux endroits des parties 6 et 8 prévus pour le soudage aux plots 24 et 26. Ensuite, la bobine 4 avec son noyau 12 et le support 18 sont déplacés en direction d'un deuxième poste de travail pour effectuer l'étape de soudage, la position relative de la bobine 4 et du circuit 2 correspondant alors, dans une vue de dessus, à la figure 1.

Une fois l'étape préliminaire au soudage effectuée, la première unité de chauffage 30 est retirée ou, dans la variante prévoyant deux postes de travail distincts pour l'étape préliminaire et l'étape de soudage, la bobine 4 est déplacée vers le poste de soudage. Les parties d'extrémité 6 et 8 sont amenées à proximité des plots 24 et 26, notamment par un déplacement vertical du circuit 2. Ensuite, soudage est effectué à l'aide d'une deuxième unité de chauffage 34 comprenant un élément de chauffage 36. Cette deuxième unité de chauffage définit une thermode conventionnelle. Comme déjà mentionné, le soudage des régions d'extrémités dénudées aux plots 24 et 26 nécessite une température nettement inférieure à la température nécessaire à l'élimination de la gaine isolante. A titre d'exemple, la température de l'élément chauffant 36 est comprise entre 100 et 150° C pour effectuer le soudage.

La figure 3 est une vue partielle agrandie de la figure 2c où l'on voit les deux régions 20 et 22 dénudées, c'est-à-dire sans gaine isolante et l'élément chauffant 36 avec un profil favorable au soudage et à la rupture des parties d'extrémité restantes du côté opposé à la bobine 4.

Selon une variante, il est prévu d'utiliser une tête à ultrasons en lieu et place de la thermode de manière à effectuer un soudage en gardant la température des plots à une valeur proche de la température ambiante. Ceci permet d'éliminer tous les risques liés à l'échauffement de ces plots et donc à leur dilatation.

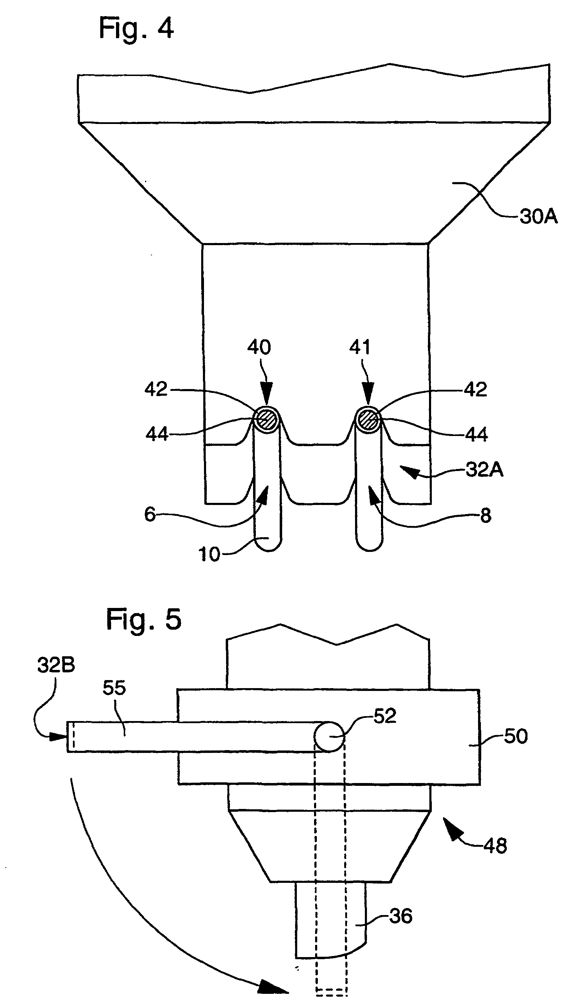

A la figure 4 est représentée une variante perfectionnée de la première unité chauffante servant à l'étape préliminaire au soudage. De manière à assurer un échauffement efficace de la gaine isolante pour la fondre ou la sublimer localement, l'unité de chauffage 30A comprend un élément chauffant 32A présentant deux ondulations en creux ou rainures 40 et 41 dans lesquelles viennent s'insérer respectivement les parties d'extrémité 6 et 8 du fil 10 de la bobine. Le profil de l'élément chauffant 32A permet ainsi de positionner correctement les deux parties 6 et 8 pour assurer un chauffage efficace de la gaine 42 sur tout le pourtour du fil métallique 44 formant le fil électrique de bobine 10. Le profil des rainures 40 et 41 peut être réalisé selon diverses variantes.

A la figure 5 est représentée une unité de chauffage 48 comprenant un premier élément de chauffage 32B pour l'étape préliminaire et un élément de chauffage 36 similaire à celui décrit à la figure 2c pour l'étape de soudage elle-même. L'élément 32B de chauffage à haute température est associé à des moyens moteur 50 permettant de faire tourner cet élément 32B autour d'un axe 52. L'élément chauffant 32B est relié à deux bras latéraux dont un 55 est visible à la figure 5. Ces bras latéraux et l'élément chauffant 32B forment un U dont les deux extrémités sont reliées aux moyens moteur 50. Par un mouvement de rotation, l'élément chauffant 32B est amené dans une position verticale, représentée en traits interrompus, pour effectuer l'étape préliminaire au soudage dans laquelle la gaine isolante du fil de bobine est localement fondue ou sublimée, comme cela a été décrit précédemment. Une fois cette étape préliminaire finie, l'élément chauffant 32B est ramené dans une position dans laquelle l'élément chauffant 36 pour le soudage est dégagé, notamment dans une position horizontale comme représentée à la figure 5. Comme cela a déjà été décrit précédemment, l'élément de chauffage 36 travaille de préférence à une température relativement peut élevée par rapport à la température de travail de l'élément chauffant 32B.

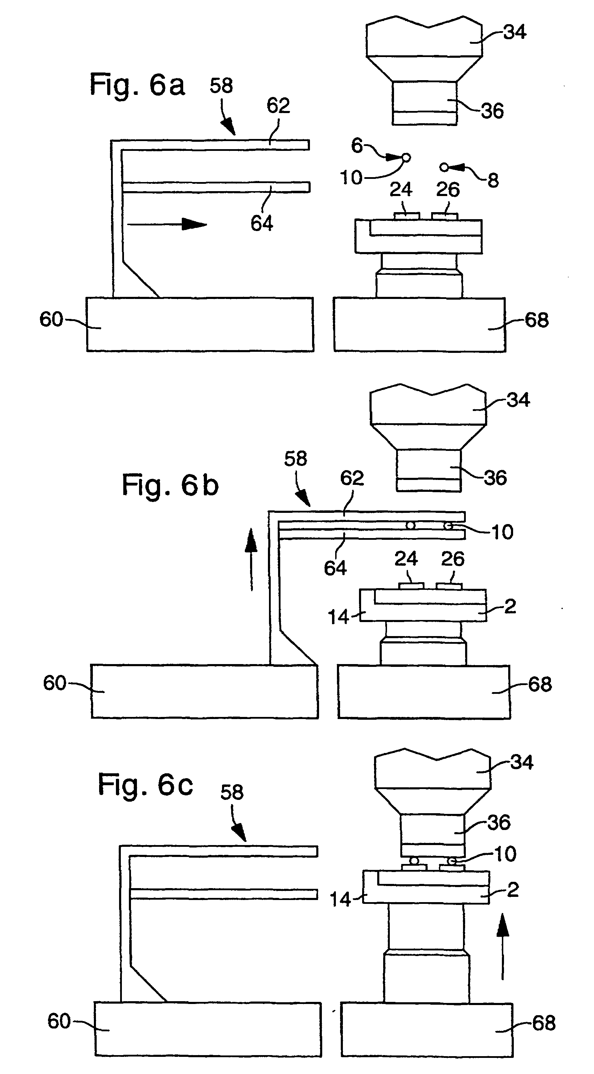

Aux figures 6a à 6c est représenté un deuxième mode de mise en oeuvre du procédé selon l'invention. Une fois le circuit électronique 2 mis en place sur son support 14 et la bobine formée et disposée pour le soudage avec ses deux parties d'extrémité 6 et 8 présentant respectivement deux régions superposées aux plots 24 et 26 du circuit 2, il est prévu dans l'étape préliminaire au soudage de maintenir les parties 6 et 8 à une certaine distance du circuit intégré 2 et d'éliminer localement la gaine isolante au moyen d'une presse chauffante 58. Cette presse chauffante 58 est montée mobile sur un socle 60 et comprend deux bras ou plateaux 62 et 64 agencés mobiles l'un relativement à l'autre de manière à pouvoir varier l'écart entre eux.

Pour effectuer l'étape préliminaire au soudage, la thermode 34 et le circuit intégré 2 sont placés à une certaine distance des parties d'extrémité 6 et 8 du fil 10 formant la bobine (non représentée aux figures 6a à 6c). La presse chauffante 58 subit alors un déplacement horizontal avec les bras ou plateaux 62 et 64 dans une position écartée, jusqu'à ce qu'au moins les régions 20 et 22 du fil 10 (voir figure 1) soient situées entre les bras ou plateaux 62 et 64. Ensuite, ces bras 62 et 64 sont rapprochés l'un de l'autre par un mouvement vertical du bras 64 jusqu'à ce que le fil 10 soit en contact avec les deux bras 62 et 64. Au moins l'un de ces deux bras est chauffé, de préférence les deux, pour fondre ou sublimer la gaine isolante entourant le fil métallique du fil de bobine 10. Ensuite, les bras 62 et 64 sont à nouveau écartés et la presse chauffante 58 et retirée. Ensuite, les parties d'extrémité 6 et 8 ayant chacune une région dénudée sont approchées des plots métalliques 24 et 26 pour être soudées sur ceux-ci. Pour ce faire, il est possible soit de déplacer les parties d'extrémité 6 et 8 relativement au circuit intégré 2, notamment en variant l'inclinaison de ces parties d'extrémité ou en variant la position relative de la bobine par rapport au circuit intégré 2. Toutefois, dans la variante préférée représentée à la figure 6c, il est prévu de déplacer le circuit intégré 2 en direction des parties d'extrémité 6 et 8. Pour ce faire, le support 14 est susceptible d'être déplacé selon une direction verticale relativement au socle 68 sur lequel il est monté. Finalement, la thermode 34 est descendue en direction des parties d'extrémité 6 et 8 pour effectuer le soudage de ces parties sur les plots de contact électrique 24 et 26 du circuit intégré 2.

## Revendications

1. Procédé de soudage des deux parties d'extrémité (6, 8) d'une bobine (10) sur deux plots ou plages de contact électrique (24, 26) d'un circuit intégré (2) ou d'une unité de petites dimensions, **caractérisé par le fait qu'**il est prévu, avant l'étape de soudage desdites deux parties d'extrémité sur lesdits deux plots ou plages, une étape préliminaire consistant à éliminer au moins partiellement la gaine isolante (42) du fil électrique (10) formant ladite bobine aux endroits des deux parties d'extrémité prévues pour le soudage de ces deux parties d'extrémité respectivement sur lesdits deux plots ou plages de contact électrique, ladite étape préliminaire étant effectuée au moyen d'un élément chauffant (32, 32A, 32B, 62, 64) mis en contact avec les deux parties d'extrémité de la bobine de manière à fondre ou sublimer ladite gaine isolante auxdits endroits prévus pour ledit soudage.

2. Procédé de soudage selon la revendication 1, **caractérisé en ce que** lesdites deux parties d'extrémité (6, 8) sont agencées au-dessus des deux plots ou plages (24, 26) dudit circuit intégré (2) ou de ladite unité électronique avant ladite étape préliminaire.

3. Procédé de soudage selon la revendication 2, **caractérisé en ce qu'**il est prévu un déplacement des deux parties d'extrémité (6, 8) en direction desdits plots ou plages (24, 26) du circuit intégré (2) entre ladite étape préliminaire et ladite étape de soudage.

4. Procédé de soudage selon l'une des revendications précédentes, **caractérisé en ce que** l'élimination de ladite gaine isolante (42) lors de ladite étape préliminaire est effectuée au moyen d'une première unité de chauffage qui est distincte de l'unité de soudage utilisée pour ladite étape de soudage, cette dernière unité étant formée par une thermode travaillant à une température relativement peu élevée ou par une tête à ultrasons qui laisse les plots ou plages (24, 26) à une température proche de la température ambiante lors de ladite étape de soudage.

5. Procédé de soudage selon l'une des revendications 1 à 3, **caractérisé en ce que** l'unité de chauffage utilisée dans ladite étape préliminaire et l'unité de soudage utilisée dans ladite étape de soudage forment ensemble un même dispositif (48) présentant un élément de chauffage (32B) sous forme de lame chauffante mobile relativement à l'élément de soudage (36).

6. Procédé de soudage selon la revendication 4 ou 5, **caractérisé en ce que** l'élément chauffant utilisé pour ladite étape préliminaire présente deux rainures pour recevoir lesdites deux parties d'extrémité (6, 8) de manière à assurer un apport de chaleur sur tout le pourtour de ladite gaine isolante (42) pour fondre ou sublimer entièrement ou quasi entièrement cette gaine isolante au moins auxdits endroits des deux parties d'extrémité prévues pour le soudage.

7. Procédé de soudage selon l'une des revendications 1 à 4, **caractérisé en ce que** ladite étape préliminaire est effectuée à l'aide d'une presse chauffante (58) déplaçable relativement auxdites deux extrémités (6, 8) du fil de bobine (10), cette presse chauffante étant formée de deux bras ou plateaux (62, 64) mobiles l'un relativement à l'autre de manière à varier l'écartement entre eux, ledit circuit intégré (2) et l'unité de soudage (34) étant maintenue à une certaine distance des parties d'extrémité (6, 8) lors de ladite étape intermédiaire de manière à permettre d'insérer entre eux les deux bras ou plateaux (62, 64) de la presse chauffante (58) pour éliminer localement ladite gaine isolante (42).

8. Procédé de soudage selon l'une des revendications précédentes, **caractérisé en ce que** la température de soudage est inférieure à 200° C.

## Patentansprüche

1. Verfahren zum Schweissen zweier Endabschnitte (6, 8) einer Spule (10) an zwei elektrischen Kontaktstellen oder -bereichen (24, 26) einer integrierten Schaltung (2) oder einer Einheit mit kleinen Abmessungen, **dadurch gekennzeichnet, dass** vor dem Schritt des Schweissens der zwei Endabschnitte an den zwei Kontaktstellen oder -bereichen ein vorbereitender Schritt vorgesehen ist, der darin besteht, die isolierende Hülle (42) des elektrischen Drahts (10), der die Spule bildet, an den Stellen der zwei Endabschnitte, die für die Schweissung dieser zwei Endabschnitte mit den zwei entsprechenden elektrischen Kontaktstellen oder -bereichen vorgesehen sind, wenigstens teilweise zu beseitigen, wobei der vorbereitende Schritt mittels eines Heizelements (32, 32A, 32B, 62, 64) ausgeführt wird, das mit den zwei Endabschnitten der Spule in der Weise in Kontakt gebracht wird, dass die isolierende Hülle an den für die Schweissung vorgesehenen Stellen geschmolzen oder sublimiert wird.

2. Schweissverfahren nach Anspruch 1, **dadurch gekennzeichnet, dass** die zwei Endabschnitte (6, 8) vor dem vorbereitenden Schritt über den zwei Kontaktstellen oder -bereichen (24, 26) der integrierten Schaltung (2) oder der elektronischen Einheit angeordnet werden.

3. Schweissverfahren nach Anspruch 2, **dadurch gekennzeichnet, dass** zwischen dem vorbereitenden Schritt und dem Schweissschritt eine Verlagerung der zwei Endabschnitte (6, 8) in Richtung zu den Kontaktstelle oder -bereichen (24, 26) der integrierten Schaltung (2) vorgesehen ist.

4. Schweissverfahren nach einem der vorhergehenden Ansprüche, **dadurch gekennzeichnet, dass** die Beseitigung der isolierenden Hülle (42) in dem vorbereitenden Schritt mittels einer ersten Heizeinrichtung, die von einer für den Schweissschritt verwendeten Schweisseinheit verschieden ist, ausgeführt wird, wobei diese letztere Einheit gebildet ist entweder aus einer Thermode, die bei einer verhältnismässig wenig hohen Temperatur arbeitet, oder aus einem Ultraschallkopf, der die Kontaktstellen oder -bereichen (24, 26) auf einer Temperatur in der Nähe der Umgebungstemperatur lässt, wenn der Schweissschritt ausgeführt wird.

5. Schweissverfahren nach einem der Ansprüche 1 bis 3, **dadurch gekennzeichnet, dass** die in dem vorbereitenden Schritt verwendete Heizeinheit und die in dem Schweissschritt verwendete Schweisseinheit zusammen dieselbe Vorrichtung (48) bilden, die ein Heizelement (32B) in Form eines relativ zu dem Schweisselement (36) beweglichen Heizplättchens aufweist.

6. Schweissverfahren nach Anspruch 4 oder 5, **dadurch gekennzeichnet, dass** das für den vorbereitenden Schritt verwendete Heizelement zwei Nuten für die Aufnahme der zwei Endabschnitte (6, 8) in der Weise, dass ein Wärmeeintrag auf dem gesamten Umfang der isolierenden Hülle (42) gewährleistet ist, aufweist, um diese isolierende Hülle wenigstens an den Stellen der zwei Endabschnitte, die für die Schweissung vorgesehen sind, vollständig oder nahezu vollständig zu schmelzen oder zu sublimieren.

7. Schweissverfahren nach einem der Ansprüche 1 bist 4, **dadurch gekennzeichnet, dass** der vorbereitende Schritt mit Hilfe einer Heizpresse (58) ausgeführt wird, die relativ zu den zwei Enden (6, 8) des Drahts der Spule (10) verlagerbar ist, wobei diese Heizpresse aus zwei beweglichen Armen oder Platten (62, 64) gebildet ist, die relativ zueinander in der Weise beweglich sind, dass der Abstand zwischen ihnen geändert wird , wobei die integrierte Schaltung (2) und die Schweisseinheit (34) in einem bestimmten Abstand von den Endabschnitten (6, 8) in dem Zwischenschritt gehalten werden, derart, dass die Einführung der zwei Arme oder Platten (62, 64) der Heizpresse (58) möglich ist, im die isolierende Hülle (42) lokal zu beseitigen.

8. Schweissverfahren nach einem der vorhergehenden Ansprüche, **dadurch gekennzeichnet, dass** die Schweisstemperatur unterhalb von 200°C liegt.

## Claims

1. Method for welding two end portions (6, 8) of a coil (10) onto two electric contact pads or bumps (24, 26) of an integrated circuit (2) or an electronic unit of small dimensions, **characterised in that**, prior to the step of welding said two end portions onto said two electric contact pads or bumps, a preliminary step is provided, consisting in removing at least partially the insulating sheath (42) from the electric wire (10) forming said coil at the locations of the two end portions provided for welding said two end portions to said electric contact pads or bumps, said preliminary step being effected by means of a heating element (32, 32A, 32B, 62, 64) put into contact with the two end portions of the coil so as to melt or sublimate said insulating sheath at said locations provided for said welding.

2. Welding method according to claim 1, **characterised in that** said two end portions (6, 8) are arranged above the two pads or bumps (24, 26) of said integrated circuit (2) or said electronic unit at a certain distance therefrom before said preliminary step.

3. Welding method according to claim 2, **characterised in that** a movement of the two end portions (6, 8) in the direction of said pads or bumps (24, 26) of said integrated circuit (2) is provided between said preliminary step and said welding step.

4. Welding method according to any of the preceding claims, **characterised in that** the removal of said insulating sheath (42) during said preliminary step is effected by means of a first heating unit which is distinct from the welding unit used for said welding step, this latter unit being formed by a thermode working at a relatively low temperature or by an ultrasound head which leaves the pads or bumps (24, 26) at a temperature close to the ambient temperature during said welding step.

5. Welding method according to any of claims 1 to 3, **characterised in that** the heating unit used in said preliminary step and the welding unit used in said welding step together form a same device (48) having a heating element (32B) in the form of a heating strip which moves relative to the welding element (36).

6. Welding method according to claim 4 or 5, **characterised in that** the heating element used for said preliminary step has two grooves for accommodating said two end portions (6, 8) so as to assure an application of heat over the entire periphery of said insulating sheath (42) to melt or sublimate entirely or almost entirely this insulating sheath at least at said locations of the two end portions provided for welding.

7. Welding method according to any of claims 1 to 4, **characterised in that** said preliminary step is effected using a heating press (58) which can be moved relative to said two ends (6, 8) of the coil wire (10), this heating press being formed of two arms or plates (62, 64) which can move relative to each other so as to vary the distance between them, said integrated circuit (2) and the welding unit (34) being held at a certain distance from the end portions (6, 8) during said intermediate step so as to allow the two arms or plates (62, 64) of the heating press (58) to be inserted between them to remove said insulating sheath (42) locally.

8. Welding method according to any of the preceding claims, **characterised in that** the welding temperature is less than 200°C.
